Europäisches Patentamt

European Patent Office

Office européen des brevets

(11) Publication number: **0 231 115 B1**

# EUROPEAN PATENT SPECIFICATION

(45) Date of publication of patent specification: **23.09.92**

(51) Int. Cl.⁵: **H01L 21/20**, H01L 21/263, H01L 21/268

(21) Application number: **87300644.9**

(22) Date of filing: **26.01.87**

(54) Method for manufacturing semiconductor devices.

(30) Priority: **24.01.86 JP 14267/86**

(43) Date of publication of application:
**05.08.87 Bulletin 87/32**

(45) Publication of the grant of the patent:
**23.09.92 Bulletin 92/39**

(84) Designated Contracting States:
**FR GB**

(56) References cited:
**EP-A- 0 167 391**
**US-A- 4 545 823**

**MICROELECTRONICS JOURNAL, vol. 14, no. 6, November/December 1983, pages 74-81, Benn Electronics Publications Ltd, Luton, Kirkcaldy, GB; T. INOUE et al.: "Electron-beam recrystallised polysilicon on silicon dioxide"**

(73) Proprietor: **SHARP KABUSHIKI KAISHA**
**22-22 Nagaike-cho Abeno-ku**
**Osaka 545(JP)**

(72) Inventor: **Seizo, Kakimoto**
**2613-1 Ichinomoto-cho**
**Tenri-shi Nara-ken(JP)**
Inventor: **Jun, Kudo**
**132-402 Nakatomigaoka 1-chome**
**Nara-shi Nara-ken(JP)**
Inventor: **Masayoshi, Koba**
**51-14-5 ShichijoNishimachi 1-chome**
**Nara-shi Nara-ken(JP)**

(74) Representative: **Brown, Kenneth Richard et al**
**R.G.C. Jenkins & Co. 26 Caxton Street**
**London SW1H 0RJ(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

JAPANESE JOURNAL OF APPLIED PHYSICS, vol. 24, no. 2, part 1, February 1985, pages 126-132, Tokyo, JP; H. ISHIWARA et al.: "Recrystallization of silicon-on-insulator structures by sinusoidally-scanned electron beams"

APPLIED PHYSICS LETTERS, vol. 47, no. 7, October 1985, pages 696-699, American Institute of Physics, Woodbury, New York, US; K. SUGURO et al.: "Seeding lateral epitaxy of silicon on insulator with improved seed and cap structure by pseudoline shaped electron beam annealing"

PATENT ABSTRACTS OF JAPAN, vol. 9, no. 225 (E-342)[1948], 11th September 1985; & JP-A-60 83 322

# Description

This invention relates to a method of manufacturing semiconductor devices, more particularly, to a method of manufacturing semiconductor devices by radiating energy beams such as electron beams to an amorphous or polycrystalline thin film to melt and recrystallise said thin film so as to promote the crystal growth of the amorphous or polycrystalline thin film to develop into a monocrystalline configuration.

Recently, the technology for monocrystallising a thin film formed as an amorphous or polycrystalline thin film and using said film as a substrate for a semiconductor has been studied intensively.

One method of manufacturing semiconductor devices is described in EP-A-0167391. This document describes the provision of a strip-shaped high melting point film on an insulation film for encouraging monocrystalline growth or recrystallisation of an amorphous or polycrystalline thin film.

Applied Physics Letters 47(7) 1/10/85 pp 696-698 describes the use of high frequency oscillation, higher beam scanning velocity, and suitable oscillation amplitude in seeding lateral epitaxy for silicon films. Seed with tapered edges are also described.

It is an aim of the present invention to provide an improved method of manufacturing semiconductor devices. Another aim is for the method to be capable of monocrystallising an amorphous or polycrystalline thin film easily, with little damage to the formed monocrystals and with excellent uniformity compared to those formed by conventional methods.

Other objects and further scope of applicability of the present invention will become apparent from the detailed description given hereinafter.

In accordance with the present invention there is provided a method of manufacturing semiconductor devices, in which a monocrystalline semiconductor thin film, provided on a first insulating film is formed by melting and recrystallising either an amorphous or a polycrystalline semiconductor thin film by annealing with an energy beam, comprising the steps of:

forming a second insulating film on said amorphous or polycrystalline film,

forming a strip-shaped compound film having a width, narrower than the diameter of said energy beam, on said second insulating film and consisting of a polycrystalline silicon film and a high melting point metal on said polycrystalline silicon film,

causing said amorphous or polycrystalline semiconductor film to contact with a monocrystalline semiconductor substrate beneath the centreline of said strip-shaped compound film at a position 50 to 200 $\mu$m remote from an end of the strip-shaped compound film in the longitudinal direction of the strip-shaped compound film, with the contact shape being a small spot, narrower than the width of the strip-shaped compound film,

radiating said energy beam, penetrating through said strip-shaped compound film to scan along the centreline of said strip, starting in the vicinity of said end of the strip and thereby;

inducing monocrystalline growth of the amorphous or polycrystalline semiconductor thin film covered with the strip-shaped compound film starting from the amorphous or polycrystalline semiconductor thin film in contact with the monocrystalline semiconductor substrate near said end of the strip-shaped compound film.

In executing this invention, it is preferable for the upper surface of the amorphous or polycrystalline thin film in the portion contacting with the monocrystalline substrate to be flush with the upper surface of the amorphous or polycrystalline thin film not in contact with the monocrystalline substrate near this contacting portion.

With this arrangement, the position of the contacting portion of the monocrystalline substrate and the amorphous or polycrystalline thin film is 50 to 200 $\mu$m remote from the end of the strip-shaped compound film in the scanning direction. This is so that when melting and recrystallising the amorphous or polycrystalline thin film beneath the strip-shaped compound film, heat from the energy beams reaches a stationary state before reaching the portion of the amorphous or polycrystalline thin film in contact with the monocrystalline substrate, when scanning starts towards the end of the strip-shaped compound film. The amorphous or polycrystalline thin film is thereby heated at the contacting portion. The contacting portion of the amorphous or polycrystalline thin film is beneath the centre line of the strip-shaped compound film, and it takes the shape of a tiny spot narrower in width than the strip-shaped compound film. The upper surface of the contacting portion of the amorphous or polycrystalline thin film is flush with the portion of the upper surface of the amorphous or polycrystalline thin film near to the contacting portion not in contact with the monocrystalline substrate. This ensures that that the heat capacity of the contacting portion of the amorphous or polycrystalline thin film and its upper part is large, and that by decreasing the surface area in contact with the monocrystalline substrate which has a large heat conduction, the heat flowing in the monocrystalline substrate can be reduced. This facilitates temperature rise in the contacting portion of the amorphous or polycrystalline thin film during melting and recrystallising. As a result, the temperature difference between the amorphous or polycrystalline thin film near the contacting portion but not in contact with the monocrystalline substrate and the portion in contact with the substrate becomes small. When sufficient energy is provided for melting the contacting portion of the amorphous or polycrystalline thin film, damage to the monocrystals formed due to an excessive rise in the temperature in the portion of the amorphous or polycrystalline thin film not in contact with the monocrystalline substrate but near to the contacting portion, may be prevented. This ensures that the decline of uniformity in the monocrystal due to deviations in crystalline configuration derived from such damage can be reduced.

In an embodiment of the invention illustrated below, the sample structure is as follows. That is, part of the amorphous thin film for monocrystallisation is caused to make contact with the monocrystalline substrate. The entire surface of this amorphous thin film is covered with a relatively thin insulation film acting as a protective film, and a strip-shaped compound film of high melting point metal such as molybdenum (Mo) and tungsten (W) and polycrystalline silicon narrower in width than the diameter of electron beams is applied starting from the vicinity of the contacting portion, and a sample substrate is prepared.

The position of the portion of the amorphous thin film in contact with the monocrystalline substrate is 50 to 200 $\mu$m remote from the end of the strip-shaped compound film in the scanning direction of beams and beneath the centre line of the strip-shaped compound film. The contacting portion takes the shape of a tiny spot smaller in width than the strip-shaped compound film. The upper surface of the contacting portion of the amorphous thin film is flush with the upper surface of the amorphous thin film adjacent the contacting portion but not in contact with the monocrystalline substrate. This is so that temperature rise of the amorphous thin film in the contacting portion is facilitated and also so that the temperature difference between adjacent portions of the amorphous thin film in contact with and not in contact with the monocrystalline substrate is reduced. Therefore, when sufficient energy for melting the amorphous thin film in the contacting portion is applied, damage to the monocrystals due to excessive rises in the temperature in the amorphous thin film adjacent the contacting portion but not in contact with the monocrystalline substrate can be prevented. This enables the decline in uniformity in the monocrystal due to deviation in crystalline configuration from such damage to be reduced.

By irradiating the substrate with electron beams, a temperature distribution optimum for monocrystalline growth is created in the same way as outlined above. By causing the amorphous thin film to contact the monocrystalline substrate at the starting point of formation of monocrystals near to the end beneath the strip-shaped compound film, monocrystals are formed in the same crystalline configuration as in the substrate. Crystal growth of the amorphous thin film beneath the strip-shaped compound thin film, starts from monocrystals having the same crystalline configuration as in the monocrystalline substrate which are generated by epitaxial growth from the monocrystalline substrate in the contacting portion.

The present invention will be better understood from the detailed description given hereinbelow and the accompanying drawings which are given by way of illustration only, and thus are not limitative of the present invention and wherein:

Figure 1 and Figure 2 are sectional views of a substrate to explain the basic steps in the manufacture of semiconductor devices;

Figure 3 is a sectional view of the substrate to explain one of the embodiments of this invention;

Figure 4 is a temperature distribution diagram in annealing process;

Figure 5 is a sectional view of the substrate to explain the recrystallisation process of the same embodiment as shown in Figure 3; and

Figure 6 is a sectional view of the substrate to explain a different embodiment of this invention.

Monocrystallisation may be achieved by providing an amorphous or polycrystalline thin film with energy by irradiation with laser beams, electron beams or the like to melt it once, and by controlling the temperature distribution and the nucleus generating position when this melted portion is solidified.

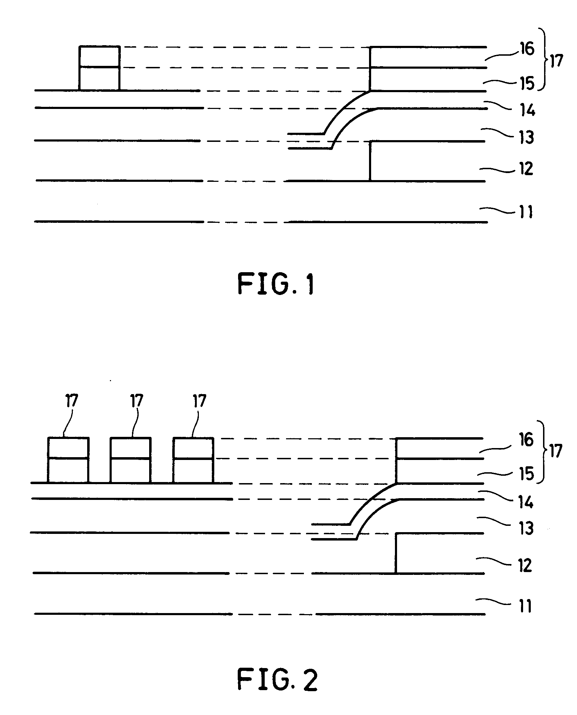

Figure 1 which is a sectional view of the substrate illustrates the basic idea of this monocrystallisation method. A monocrystalline substrate 11 made of silicon or other material is used as a support stand, and an insulation film 12 made of $SiO_2$ $Si_3N_4$ or similar material is formed on the surface of this monocrystalline substrate 11. A polycrystalline silicon film 13 for monocrystallisation is formed on the surface of this insulation film 12, and an insulation film 14 made of $SiO_2$, $Si_3N_4$ or similar material is formed on the surface of this polycrystalline silicon film 13. A polycrystalline silicon film 15 and a high melting point metal film 16 made of molybdenum (Mo), tungsten (W) or other material are formed on the surface of this insulation film 14 to form a strip-shaped compound film 17. The width of the strip-shaped compound film 17 is smaller than the diameter of the electron beams, and it is set, for example, to be between 10 and 20 $\mu$m.

The laminated structure is irradiated with electron beams to provide the energy to monocrystallise the polycrystalline region 13.

On both sides of the strip-shaped compound film 17, the electron beams heat the monocrystalline silicon film 13 only through the insulating film 14. However, beneath the compound film 17, because the electron reflectivity and inhibiting ability of the high melting point metal film 16 are high, the energy of the electron beams is decreased by reflection, and fully absorbed within the thin film 17. The thin film 17 itself rises in temperature, and heats the thin film 13 by conduction.

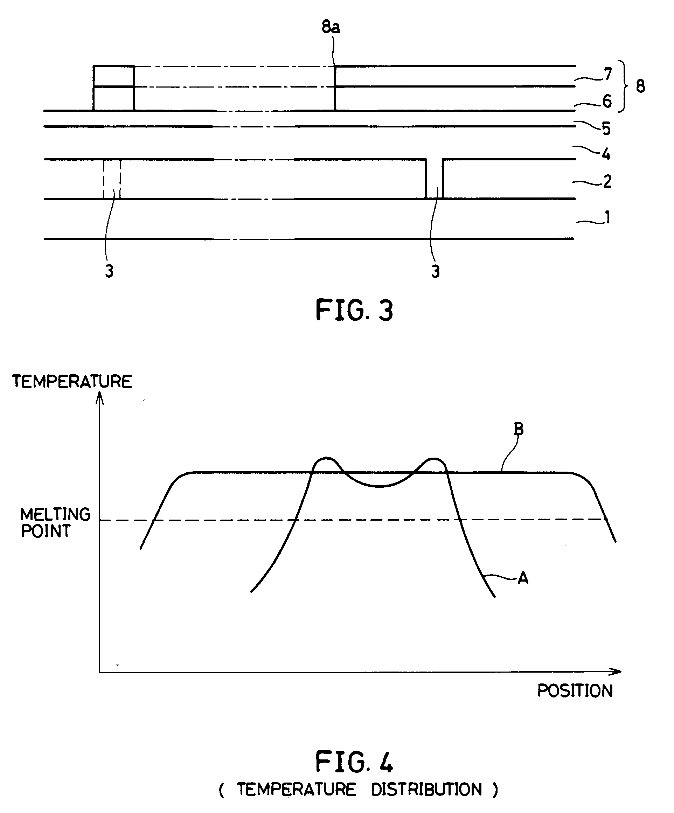

Therefore, the strip-shaped compound film 17 arrests the temperature rise of the amorphous thin film 13 to produce a temperature profile lower in the middle of the melted portion than in the peripheral portions as indicated by curve A in Figure 4. Therefore, during melting and recrystallising, the compound film 17 serves to present a solid-liquid boundary shape and nucleus generating position suitable for monocrystallisation. The polycrystalline silicon film 15 alleviates the thermal stress that occurs between the insulation film 14 and the high melting point metal film 16 during heating.

Besides, in the manufacturing of semiconductor devices shown in Figure 1, the portion of the polycrystalline silicon film 13 not covered by the strip-shaped compound film 17 near the end of the strip-shaped compound film 17 designed to be the starting point of monocrystallisation, contacts the monocrystalline substrate 11 directly. Consequently, when the polycrystalline silicon 13 beneath the strip-shaped compound film 17 grows in crystallisation from the seeds of the monocrystals having the same crystalline configuration as the monocrystalline substrate 11 developed by epitaxial growth from the monocrystalline substrate 11 in that portion, the monocrystals are formed so that the configuration is the same as that of the substrate 11.

Figure 2 is a sectional view of another substrate for application of the method of manufacturing semiconductor devices described in relation to Figure 1. The compound film 17 of this substrate forms a plurality of strips each having a width of 10 $\mu$m to 20$\mu$m, spaced apart by a distance of 5 $\mu$m. When a plurality of electron beam absorbing films 17 are simultaneously annealed by triangular wave deflection pseudoline beams having a flat energy distribution as indicated by characteristic curve B in Figure 4, the temperature distribution is controlled by the electron beam absorbing films 17 in the same way as described with reference to Figure 1. A plurality of monocrystalline regions are thereby formed. Since the widths of the monocrystalline regions are greater than those of the corresponding strip-shaped compound film 17, the monocrystalline regions can be linked by setting the plurality of strips and the spaces between them to have dimensions in the ranges specified above.

The crystalline configuration of each of the monocrystalline regions is the same as that of the monocrystalline substrate 11 as described in relation to Figure 1, so that crystalline boundaries are not formed between adjacent monocrystals. As a result, a large-area monocrystal, with nearly the same width as the pseudoline electron beam, is formed.

With the method described above, however, as a result of various investigations, it has been found that the configuration and shape of the portion of the amorphous or polycrystalline thin film in contact with the monocrystalline substrate and its relation to the strip-shaped compound film are disadvantageous causing damage to the monocrystals formed and greatly affecting the uniformity of crystals. This results in poor reproducibility.

For example, with the configuration shown in Figure 1, the portion of the polycrystalline silicon 13 contacting the monocrystalline substrate 11 is linear in shape and perpendicular to the strip-shaped compound film which runs across the strip-shaped compound film 17. The surface area of the portion contacting the highly heat conductive monocrystalline substrate 11 is large and the strip-shaped compound film 17 is not provided on the polycrystalline silicon 13 at the contacting portion.

The film thickness of the polycrystalline silicon 13 of the contacting portion is the same as that of the polycrystalline silicon 13 not in contact with the monocrystalline substrate 11 near the contacting portion. In addition, the heat capacity of the polycrystalline silicon in the contacting portion is smaller than that of the amorphous or polycrystalline thin film which is around that portion and not in contact with the monocrystalline substrate 11.

Therefore, when melting and recrystallisation by energy beams takes place, as the portion that contacts the monocrystalline substrate 11 has a higher thermal conductivity, the heat conduction is great. Moreover, since the heat in that portion is small, the temperature difference between the polycrystalline silicon 13 in the contacting portion and the polycrystalline silicon 13 not in contact with the monocrystalline substrate 11 near the contacting portion becomes excessive. In this situation, if energy sufficient to melt the polycrystalline silicon 13 in the contacting portion is provided by the energy beams, damage such as scattering and a reduction in film thickness occurs in the polycrystalline silicon 13 near to the contacting portion. The crystalline configuration of the monocrystals formed is also likely to be deviated by the damage, and the uniformity of the formed monocrystals decreased.

The present invention provides an improved method for the manufacture of semiconductor devices with the intention of providing a method for the manufacture of semiconductor devices capable of monocrystallising an amorphous or polycrystalline thin film easily with less damage to the monocrystals formed and excellent uniformity in comparison with conventional methods.

Figure 3 is a sectional view of the substrate to explain an embodiment of this invention, in which sections in two orthogonal directions are indicated on the right and left of the Figure. The right side of Figure 3 indicates the vicinity of starting point of energy beam scanning near the end of the strip-shaped compound film.

In Figure 3, an insulation film 2 made of $SiO_2$, $Si_3N_4$ or similar material is formed on a monocrystalline substrate 1 made of silicon or other material. An opening 3 to trigger epitaxial growth from the substrate at the time of dissolving and recrystallising is provided in part of the insulation film 2, and an opening seed is formed by exposing the substrate 1. On the surface of the insulating film 2 and the exposed part of the substrate, an amorphous or polycrystalline film 4 for monocrystallisation is formed. The amorphous or polycrystalline silicon film 4 is formed so that the upper surface of the amorphous or polycrystalline silicon film in contact with the monocrystalline substrate 1 may be flush with the upper surface of the amorphous or polycrystalline silicon film not in contact with the substrate 1 near to the contacting portion.

An insulation film 5 made of $SiO_2$, $Si_3N_4$ or similar material is formed on the surface of the amorphous or polycrystalline silicon film 4. A compound film 8 is formed on the portion containing the opening 3 where the polycrystalline silicon film 4 beneath the insulation film 5 on the surface of this insulation film 5 contacts the substrate. The compound film 8 comprises a polycrystalline silicon film 6 to alleviate the thermal stress when annealing, and a high melting point metal film 7 made of molybdenum (Mo), tungsten (W) or other material with a large electron inhibiting ability and high electron reflectivity. The compound film 8 of the high melting point metal film 7 and polycrystalline silicon film 6 is patterned to form a strip-shape, smaller in width than the diameter of the annealing electron beams. For example, the width being in the range of 10 to 20 $\mu$m. Moreover, the compound film 8 is patterned so that the position of the opening 3 providing a contact between the monocrystalline substrate 1 and amorphous or polycrystalline silicon film 4 may be located beneath the centre line of the inside strip-shaped compound film 8 between 50 to 200 $\mu$m from the end 8a in the scanning direction of energy beams of the strip-shaped compound film 8. The opening 3 is narrower than the width of the strip-shaped compound film 8 and is, for example, a spot opening 2 to 5 $\mu$m in diameter.

With this configuration, the electron beams heat the polycrystalline silicon film 4 directly on each side of the strip-shaped compound film 8, but beneath the strip-shaped compound film 8, since the electron reflectivity and electron inhibiting ability of this compound film 8 are high, the energy of electron beams is decreased by reflection allowing it to be completely absorbed within the strip-shaped compound film 8. The temperature accordingly rises within the strip-shaped compound film 8 and the heat is transferred to the polycrystalline silicon film 4 through conduction. In this way the strip-shaped compound film 8 controls the temperature rise of the polycrystalline silicon film 4 to produce a temperature profile lower in the middle part than in the peripheral parts as indicated by curve A in Figure 4. An optimum temperature profile for inducing monocrystal growth at the time of dissolving and recrystallising is thereby provided.

Incidentally, since this compound film 8 prevents the electrons from reaching the portion to be monocrystallised directly, the method of the present invention is effective to decrease electron damage to the monocrystallised film.

Since the polycrystalline silicon film 4 contacts the monocrystalline substrate 1 at opening 3, monocrystals inheriting the crystalline configuration of the monocrystalline substrate 1 are formed in this part by the epitaxial growth from the monocrystalline substrate 1 during melting and recrystallisation. These become seed crystals for monocrystal growth of the polycrystalline silicon film 4 beneath the strip-shaped compound film 8, thereby enabling the crystalline configuration to be controlled.

The position of the opening 3 where contact between the monocrystalline substrate 1 and polycrystalline silicon film 4 occurs is beneath the centre line of the strip-shaped compound film 8 50 to 200 $\mu$m from the end 8a of the strip-shaped compound film 8 in the scanning direction of energy beams. It is narrower than the width of the strip-shaped compound film 8, for example, 2 to 5 $\mu$m, and the upper surface of the polycrystalline silicon not in contact with the monocrystalline substrate 1 is flush with the upper surface of the polycrystalline silicon that makes contact with the substrate 1 at the opening 3. The configuration facilitates the temperature rise of the polycrystalline silicon in the contacting portion during melting and recrystallising. As a result the temperature difference between the polycrystalline silicon not contacting with the monocrystalline substrate 1 near the contacting portion and the contacting portion is reduced. Accordingly, if sufficient energy is applied to melt the polycrystalline silicon of the contacting portion, damage due to an excessive rise in the temperature of the polycrystalline silicon near to the contacting portion but not in contact with the monocrystalline substrate 1 is prevented. A reduction in the uniformity of crystals as a result of such damage is also thereby suppressed.

The thickness of the electron beam absorbing compound film 8 is set to be greater than the range of electrons used in the electron beams so as to absorb 100% of the energy of the electrons within the film and to suppress peeling of the electron absorbing film 8 due to thermal stress at the time of annealing.

If electron beams with an acceleration voltage of 10 kV are used for annealing, the range of the electrons is around 500 nm. With a film 7 formed, for example, of Molybdenum (Mo) the electron inhibiting ability of the polycrystalline silicon is about 1/5 that of molybdenum. The thickness of the molybdenum is set to be 400 to 600 nm and the thickness of the polycrystalline silicon film 500 to 1,000 nm, in consideration of the suppression of molybdenum, peeling and the controlling effect on the temperature distribution by heat conduction within the electron beam absorbing film 8.

The insulation film 5 covering the thin film 4 delays heat conduction from the electron absorbing film 8, prevents damage due to direct entry of electron beams into the thin film 4, and contamination due to direct contact between the thin film 4 and the electron beam absorbing film 8. The thickness of the insulation film 5 is set to be between about 400 and 600 nm in order to lower the temperature beneath the thin film 8 due to the conduction of heat generated by the thin film 8 through the insulation film 5.

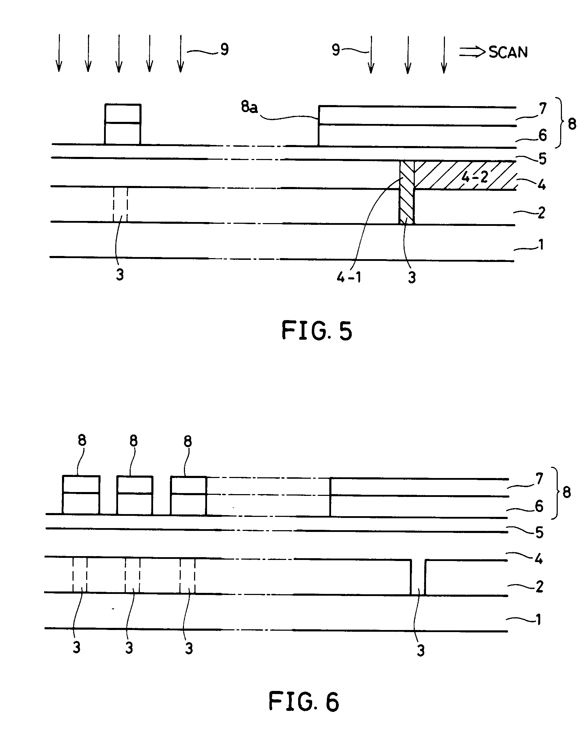

Figure 5 is a sectional view of the substrate for use in explaining the recrystallisation process using a method of this invention, in which sections in orthogonal directions are indicated on the right and left of the Figure. If beam scanning is toward the right in the right-side drawing, the beam scanning direction is perpendicular to the paper surface in the left-side drawing.

In Figure 5, electron beams 9 irradiate the laminate structure of the substrate so that the centres of the electron beams 9 are located in the middle of the electron beam absorbing film 8 for penetrating the electron beam absorbing film 8. The electron beams 9 scan parallel to the strip-shaped electron beam absorbing film 8, starting from the vicinity of the end 8a of the electron beam absorbing film 8. As a result, monocrystals having the same crystalline configuration as the monocrystalline substrate 1 are formed by epitaxial growth from the monocrystalline substrate 1 first in the part 4-1 of the polycrystalline silicon film 4. Due to the difference between heat conducted to the part 4-1 of the polycrystalline silicon film 4 and to the lower part of the part 4-2 of the polycrystalline silicon film 4 and to the temperature gradient in the horizontal direction occurring due to electron beam scanning, the monocrystals formed in the part 4-1 extend to the part 4-2, forming seed crystals for crystal growth in the part 4-2 of the polycrystalline silicon.

The part 4-1 (opening seed) is located 50 to 200 $\mu$m from the end 8a of the electron beam absorbing strip-shaped compound film 8 in the scanning direction. As a consequence, when the electron beams 9 scan starting from the vicinity of the end 8a of the electron beam absorbing film 8, the electron beams 9 reach the part 4-1 only after reaching a thermally stationary state. The part 4-1 is beneath the centre line of the electron beam absorbing film 8 and narrower than the width of the electron beam absorbing film 8, being, for example, a spot of 2 to 5 $\mu$m in diameter. The upper surface of the part 4-1 is flush with the upper surface of the part 4-2. This provides that the heat capacity of the part 4-1 and its upper part is large and the heat flowing into the monocrystalline substrate 1 that has a large heat conductivity becomes smaller. A temperature rise in the part 4-1 may thereby be facilitated and the temperature difference between the part 4-1 and the part 4-2 reduced. Therefore, when sufficient energy is applied to melt the part 4-1, an excessive rise of the temperature of part 4-2 is prevented. Damage to the part 4-2 can thereby be avoided, so that a reduction in the uniformity of crystals due to such defects are SURPRESSED.

Of the part of the film exposed to the electron beams 9, the portion not covered with the electron beam absorbing film 8 receives the electron beams 9 through the insulation film 5. The temperature of this portion goes up. In the portion covered with electron beam absorbing film 8, however, part of the electron beam 9 is reflected, while the remainder is absorbed by the electron beam absorbing film 8, so that the temperature of the electron beam absorbing film 8 goes up. This heat is conducted to the part 4-2 of the polycrystalline silicon film 5 through the insulation film 5. The temperature immediately beneath the electron beam absorbing film 8, is lower than in the peripheral parts due to energy loss through the reflection of electrons by the electron beam absorbing film 8 and the temperature drop due to heat conduction in the thin film 8 and insulation film 5. A temperature profile suitable for monocrystal growth is thereby formed providing a lower temperature in the middle part and a higher temperature in the peripheral parts as indicated by curve A in Figure 4. Monocrystals are accordingly formed having the same crystalline configuration as the monocrystalline substrate 1, starting from the monocrystals having the same crystalline configuration as in the monocrystalline substrate 1 which have been developed by epitaxial growth from the monocrystalline substrate 1 in the part 4-1 of the polycrystalline silicon film 4 and extended toward the part 4-2.

As the temperature distribution suitable for monocrystallisation is realised by the electron beam absorbing film 8, the stability of monocrystal growth starting from the monocrystals of the part 4-2 of the polycrystalline silicon 4 generated in part 4-1 is enhanced as compared to conventional lateral seeding epitaxial growth methods not using an electron beam absorbing film 8.

After monocrystallising by annealing, the electron beam absorbing film 8 and insulation film 5 are removed by etching, and, for example, by photolithography, a monocrystalline region is processed in a shape presented for the fabrication of a semiconductor element.

Figure 6 comprises two orthogonal sectional views of the substrate to explain a further different embodiment of this invention, in which the same parts as in Figure 3 are identified with same part numbers. It shows a substrate structure for producing large-area monocrystals having a nearly same width as the pseudoline electron beam by annealing with pseudoline electron beams.

In this embodiment, a plurality of strips of electron beam absorbing film 8 similar in shape to those used in the preceding embodiment are formed on the insulation film 5. The strips are each about 10 to 20 $\mu$m wide, and are spaced apart by 5 $\mu$m. The pseudoline electron beams have an acceleration voltage of 5 to 10 kV, and a beam current of 1.0 to 5.0 mA. The spot-shaped electron beams having a gaussian energy distribution of beam diameter 100 to 200 $\mu$m are formed in an alternating-current voltage waveform such as triangular wave (the triangular wave frequency being 100 kHz to 50 MHz) by deflecting in a width of 500 to 2,000 $\mu$m in the direction vertical to the scanning direction to provide a broad and uniform temperature distribution indicated by curve B in Figure 4. Using such pseudoline electron beams, by simultaneously annealing the region containing a plurality of stripes of electron beam absorbing film 8, a plurality of monocrystalline regions are formed. Since the width of the monocrystalline region extends beyond the width of the striped high melting point metal film, the monocrystalline regions can be linked together by setting the line and space dimensions to fall within the above stated ranges. Because the crystalline configuration of each of the monocrystalline regions is the same as that of the monocrystalline substrate 1 in the case shown in Figure 5, crystal boundaries are not formed between the adjacent monocrystals. Large-area monocrystals nearly equal in width to the pseudoline electron beams can therefore be formed.

## Claims

1. A method of manufacturing semiconductor devices, in which a monocrystalline semiconductor thin film, provided on a first insulating film (2) is formed by melting and recrystallising either an amorphous or a polycrystalline semiconductor thin film (3, 4) by annealing with an energy beam, comprising the steps of:

   forming a second insulating film (5) on said amorphous or polycrystalline film,

   forming a strip-shaped compound film (8) having a width, narrower than the diameter of said energy beam, on said second insulating film and consisting of a polycrystalline silicon film (6) and a high melting point metal (7) on said polycrystalline silicon film,

   causing said amorphous or polycrystalline semiconductor film to contact with a monocrystalline semiconductor substrate (1) beneath the centreline of said strip-shaped compound film (8) at a position 50 to 200 $\mu$m remote from an end of the strip-shaped compound film in the longitudinal direction of the strip-shaped compound film, with the contact shape being a small spot, narrower than the width of the strip-shaped compound film,

   radiating said energy beam, penetrating through said strip-shaped compound film to scan along the centreline of said strip, starting in the vicinity of said end of the strip and thereby

   inducing monocrystalline growth of the amorphous or polycrystalline semiconductor thin film covered with the strip-shaped compound film starting from the amorphous or polycrystalline semiconductor thin film (3) in contact with the monocrystalline semiconductor substrate near said end of the strip-shaped compound film.

2. A method of manufacturing semiconductor devices as defined in claim 1, wherein the upper surface of the portion of said amorphous or polycrystalline semiconductor film in contact with the monocrystalline substrate is flush with the upper surface of the amorphous or polycrystalline thin film not contacting with the monocrystalline substrate adjacent the portion in contact with the monocrystalline substrate strip.

3. A method of manufacturing semiconductor devices as defined in claim 1 or 2, wherein the energy beams to be used are spot electron beams having a gaussian energy distribution, or pseudoline electron beams formed by deflecting and scanning said beams at high speed by applying an alternating-current voltage in triangular wave vertically to the scanning direction of the spot electron beams.

4. A method of manufacturing semiconductor devices as defined in claim 3, wherein said spot electron beams or pseudoline electron beams have an acceleration voltage of 5 to 20 kV, a beam diameter of 100 to 200 $\mu$m in spot electron beams, and, in pseudoline electron beams, the deflection of spot electron beams to a width of 500 to 2,000 $\mu$m.

5. A method of manufacturing semiconductor devices as defined in claim 4, wherein the width of said strip-shaped high melting point metal film is set to 10 to 20 $\mu$m when annealing by spot electron beams, and is formed in a plurality of strips, with the width of each strip measuring 10 to 20 $\mu$m and the space between strips being 5 $\mu$m, when annealing with pseudoline electron beams.

6. A method of manufacturing semiconductor devices according to any one of claims 3 to 5 wherein the thickness of the strip-shaped compound film (8) is sufficient to totally absorb the energy of the electron beams.

## Patentansprüche

1. Verfahren zur Herstellung von Halbleiter-Bauelementen, bei welchem ein monokristalliner Halbleiter-Dünnfilm, der auf einem ersten isolierenden Film (2) bereitgestellt wird, durch Schmelzen und Rekristallisieren entweder eines amorphen oder eines polykristallinen Dünnfilms (3,4) durch Tempern mit einem Energiestrahl gebildet wird, welches die folgenden Schritte umfaßt:
Bildung eines zweiten isolierenden Films (5) auf dem amorphen oder polykristallinen Film,
Bildung eines streifenförmigen Verbundfilms (8) mit einer Breite, die geringer als der Durchmesser des Energiestrahls ist, auf dem zweiten isolierenden Film, und welcher Verbundfilm aus einem polykristallinen Siliziumfilm (6) und einem Film aus einem Metall (7) mit hohem Schmelzpunkt, auf dem polykristallinen Siliziumfilm besteht,
Bewirken, daß der amorphe oder polykristalline Film mit einem monokristallinen Halbleitersubstrat (1) unter der Mittellinie des streifenförmigen Verbundfilms (8) in einer Position in Kontakt kommt, die 50 bis 200 $\mu$m von einem Ende des streifenförmigen Verbundfilms in der Längsrichtung des streifenförmigen Verbundfilms entfernt ist, wobei die Kontaktform ein kleiner Fleck ist, schmaler als die Breite des streifenförmigen Verbundfilms,

Bestrahlen mit dem Energiestrahl, der durch den streifenförmigen Verbundfilm hindurchdringt, um entlang der Mittellinie des Streifens beginnend in der unmittelbaren Nähe des Streifenendes entlangzufahren und dadurch Einleiten eines monokristallinen Wachstums des amorphen oder polykristallinen Halbleiterdünnfilms, der mit dem streifenförmigen Verbundfilm bedeckt ist, beginnend von dem amorphen oder polykristallinen Halbleiter-Dünnfilm (3), der in Kontakt mit dem monokristallinen Halbleitersubstrat steht, nahe des Endes des streifenförmigen Verbundfilms.

2. Verfahren zur Herstellung von Halbleiter-Bauelementen nach Anspruch 1, wobei die Oberseite des Teils des amorphen oder polykristallinen Halbleiterfilms, die mit dem monokristallinen Substrat in Kontakt steht, bündig mit der Oberseite des amorphen oder polykristallinen Dünnfilms ist, die nicht in Kontakt mit dem monokristallinen Substrat angrenzend an den Teil steht, der mit dem monokristallinen Substratstreifen in Kontakt steht.

3. Verfahren zur Herstellung von Halbleiter-Bauelementen nach Anspruch 1 oder 2, wobei die zu verwendenden Energiestrahlen punktförmige Elektronenstrahlen sind, die eine Gauß'sche Energieverteilung haben oder Pseudolinien-Elektronenstrahlen, die durch Ablenken und Abtasten der Strahlen mit hoher Geschwindigkeit durch Anlegen einer Wechselspannung in Form einer Dreieckswelle vertikal zur Überstreichrichtung der punktförmigen Elektronenstrahlen gebildet werden.

4. Verfahren zur Herstellung von Halbleiter-Bauelementen nach Anspruch 3, wobei die punktförmigen Elektronenstrahlen oder Pseudolinien-Elektronenstrahleneine Beschleunigungsspannung von 5 bis 20 kV, einen Strahlendurchmesser von 100 bis 200 $\mu$m bei punktförmigen Elektronenstrahlen haben und bei Pseudolinien-Elektronenstrahlen die Abweichung von punktförmigen Elektronenstrahlen auf eine Breite von 500 bis 2000 $\mu$m erfolgt.

5. Verfahren zur Herstellung von Halbleiter-Bauelementen nach Anspruch 4, wobei die Breite des streifenförmigen Films aus einem Metall mit hohem Schmelzpunkt auf 10 bis 20 $\mu$m festgelegt wird, wenn ein Tempern durch punktförmige Elektronenstrahlen erfolgt, und aus einer Vielzahl von Streifen gebildet wird, wobei die Breite jedes Streifens 10 bis 20 $\mu$m und der Abstand zwischen den Streifen 5 $\mu$m beträgt, wenn ein Tempern mit Pseudolinien-Elektronenstrahlen erfolgt.

6. Verfahren zur Herstellung von Halbleiter-Bauelementen nach einem der Ansprüche 3 bis 5, wobei die Dicke des streifenförmigen Verbundfilms (8) ausreichend ist, um die Energie der Elektronenstrahlen vollständig zu absorbieren.

## Revendications

1. Une méthode de fabrication de dispositifs semi-conducteurs, dans laquelle un film mince semi-conducteur monocristallin, disposé sur un premier film isolant (2), est formé en fondant et en recristallisant un film mince semi-conducteur soit amorphe soit polycristallin (3, 4) par recuit avec un faisceau d'énergie, comprenant les étapes de :

formation d'un second film isolant (5) sur ledit film amorphe ou polycristallin,

formation d'un film composé en forme de bande (8), possédant une largeur inférieure au diamètre dudit faisceau d'énergie, sur ledit second film isolant et consistant en un film de silicium polycristallin (6) et en un métal à point de fusion élevé (7) sur ledit film de silicium polycristallin,

mise en contact dudit film semi-conducteur amorphe ou polycristallin avec un substrat semi-conducteur monocristallin (1) sous l'axe médian dudit film composé en forme de bande (8) en un point éloigné de 50 à 200 $\mu$m d'une extrémité du film composé en forme de bande dans le sens longitudinal du film composé en forme de bande, la forme du contact étant un petit point plus étroit que la largeur du film composé en forme de bande,

rayonnement dudit faisceau d'énergie, pénétrant à travers ledit film composé en forme de bande pour balayer l'axe médian de ladite bande, en commençant à proximité de ladite extrémité de la bande et induisant ainsi une

croissance monocristalline du film mince semi-conducteur amorphe ou polycristallin recouvert du film composé en forme de bande, en commençant à partir du film mince semi-conducteur amorphe ou polycristallin (3) en contact avec le substrat semi-conducteur monocristallin près de ladite extrémité du film composé en forme de bande.

2. Une méthode de fabrication de dispositifs semi-conducteurs telle que définie à la revendication 1, dans laquelle la surface supérieure de la portion dudit film semi-conducteur amorphe ou polycristallin en contact avec le substrat monocristallin est alignée avec la surface supérieure du film mince amorphe ou polycristallin qui n'est pas en contact avec le substrat monocristallin adjacent à la portion en contact avec la bande de substrat monocristallin.

3. Une méthode de fabrication de dispositifs semi-conducteurs telle que définie à la revendication 1 ou 2, dans laquelle les faisceaux d'énergie utilisés sont des faisceaux d'électrons en forme de point ayant une distribution d'énergie gaussienne, ou des faisceaux d'électrons en pseudoligne formés en défléchissant et en balayant lesdits faisceaux à vitesse élevée en appliquant une tension de courant alternatif en onde triangulaire verticalement au sens de balayage des faisceaux d'électrons en forme de point.

4. Une méthode de fabrication de dispositifs semi-conducteurs telle que définie à la revendication 3, dans laquelle lesdits faisceaux d'électrons en forme de point ou faisceaux d'électrons en pseudoligne ont une tension d'accélération de 5 à 20 kV, un diamètre de faisceau de 100 à 200 $\mu$m dans les faisceaux d'électrons en forme de point, et, dans les faisceaux d'électrons en pseudoligne, la déflexion de faisceaux d'électrons enforme de point atteint une largeur de 500 à 2 000 $\mu$m.

5. Une méthode de fabrication de dispositifs semi-conducteurs telle que définie à la revendication 4, dans laquelle la largeur dudit film en forme de bande en métal à point de fusion élevé est comprise entre 10 et 20 $\mu$m lors du recuit par des faisceaux d'électrons en forme de point, et est formée en une pluralité de bandes, la largeur de chaque bande mesurant de 10 à 20 $\mu$m et l'espace entre les bandes étant de 5 $\mu$m, lors du recuit avec des faisceaux d'électrons en pseudoligne .

6. Une méthode de fabrication de dispositifs semi-conducteurs conforme à l'une quelconque des revendications 3 à 5, dans laquelle l'épaisseur du film composé en forme de bande (8) est suffisante pour absorber totalement l'énergie des faisceaux électroniques.

FIG. 1

FIG. 2

8a

7
6
} 8
5
4
2
1

3                                    3

# FIG. 3

TEMPERATURE

MELTING
POINT

B

A

POSITION

# FIG. 4
( TEMPERATURE  DISTRIBUTION )

FIG. 5

FIG. 6